# EUROPEAN PATENT APPLICATION

(11) **EP 1 840 956 A1**
(43) Date of publication of application: **03.10.2007**
(21) Application number: 07006288.0
(22) Date of filing: 27.03.2007
(51) Int. Cl.: H01L 21/762, H01L 21/66

(54) **Method of producing simox wafer**

(30) Priority: 27.03.2006 JP 2006085429
(71) Applicant: SUMCO Corporation, Tokyo 105-8634 (JP)
(72) Inventor: Murakami, Yoshio, c/o Sumco Corp., Tokyo 105-8634 (JP); Okita, Kenji, c/o Sumco Corp., Tokyo, 105-8634 (JP)
(74) Representative: Röthinger, Rainer

(57) **Abstract**

A SIMOX wafer is produced by implanting oxygen ions into a surface of a Si substrate and then conducting a high-temperature annealing, in which a SOI film having a thickness thicker than a target SOI film thickness is previously formed and a final adjustment of the SOI film thickness is carried out at an etching step arranged separately from a cleaning step.

## Description

### BACKGROUND OF THE INVENTION

### 1. Field of the Invention

This invention relates to a thin film SOI wafer having a buried oxide film (BOX) for forming a high-speed, low power consumption SOI (silicon on insulator) device, and more particularly to a method of producing a SIMOX (separation by implanted oxygen) wafer in which a buried oxide film is formed by implanting oxygen ions into a surface of a wafer and then annealing at a high temperature. Particularly, the invention relates to a method of effectively adjusting a thickness of SOI film in the SIMOX wafer.

### 2. Description of Related Art

As a method of producing a thin film SOI wafer, there have hitherto been known a so-called high-dose SIMOX method wherein a dose in the oxygen implantation is high, and a so-called low-dose SIMOX method wherein oxygen ions are implanted at a dose lower by about one significant digit than that of the high-dose SIMOX method and then the annealing is carried out in a high oxygen atmosphere.

As the low-dose SIMOX method is recently developed a so-called MLD (modified low dose) method wherein the formation of BOX at a lower dose is made possible by conducting a final oxygen implantation at a lower dose and about room temperature to form an amorphous layer, which contributes to the mass production of wafers.

The high-dose SIMOX method is a method wherein oxygen ions are implanted under conditions of an acceleration energy: 150 keV, a dose: more than 1.5x10¹⁸ cm⁻² and a substrate temperature: about 500°C and thereafter the annealing is carried out at a temperature of higher than 1300°C in argon (Ar) or nitrogen (N₂) atmosphere containing 0.5-2% of oxygen for about 4-8 hours (see K. Izumi et al., Electron lett. (UK) vol. 14, (1978), p.593). However, the high-dose SIMOX method have problems that the implantation time is very long and the throughput is bad and the dislocation density of SOI layer is as very high as 1x10⁵-1x10⁷ cm⁻².

The low-dose SIMOX method improves the above problems of the high-dose SIMOX method, and is typically carried out by implanting oxygen ions under conditions of an acceleration energy: more than 150 keV, a dose: 4x10¹⁷-1x10¹⁸ cm⁻² and a substrate temperature: about 400-600°C and thereafter conducting the annealing at a temperature of higher than 1300°C in an argon atmosphere containing 30-60% of oxygen, whereby there is attained a significant quality improvement that the buried oxide film (BOX) is thickened by an internal thermal oxidation (which may be abbreviated as "ITOX") at the annealing step and the dislocation density is reduced and the like (see S. Nakashima et al., Proc. IEEE int. SOI Conf. (1994), p71-72).

Further, the MLD method is developed as an improved version of the low-dose SIMOX method, and is a method wherein after the existing oxygen implantation at a high temperature (400-650°C), a further oxygen implantation of a dose lower by one significant digit is carried out at room temperature to form an amorphous layer on the surface of the buried oxide film (BOX) (see O. W. Holland et al., Appl. Phys. Lett. (USA) vol. 69 (1996), p574 and U.S. Patent No. 5930643). According to this method, it is possible to conduct the continuous growth of BOX within a wide and low dose range of 1.5x10¹⁷-6x10¹⁷ cm⁻², and also even in the subsequent ITOX process, the internal thermal oxidation may be conducted at a rate higher by 1.5 times than that of the conventional ITOX. As a result, the BOX film is very near to the thermal oxide film, and a significant quality improvement is attained. In the MLD method, it is common that the annealing is carried out in an Ar atmosphere containing 0.5-2% of oxygen for about 5-10 hours after the ITOX step in order to decrease an oxygen content in SOI layer.

As a most important factor of SOI wafer produced by the above SIMOX methods is a thickness of SOI film. In general, the thickness of the SOI film largely influences conditions of subsequent device process and device characteristics, so that it is required to have a uniformity of about ± 3 nm.

It has been revealed that the factor influencing the thickness of the SOI film is related to many conditions at SIMOX process step. In the initial implantation step, all of an implantation energy, an implantation dose and an implantation temperature influence the thickness of the SOI film. Also, in the subsequent high-temperature annealing step, an annealing temperature, an annealing time, an oxygen partial pressure in the annealing and the like largely influence the thickness of the SOI film.

In the production step of SIMOX wafer, however, it is very difficult to precisely control all of these factors influencing the thickness of the SOI film without fluctuation every time, and hence there is a problem that the SOI film deviates from its specification.

### SUMMARY OF THE INVENTION

Under the above situations, it is an object of the invention to propose a method of advantageously producing a SIMOX wafer wherein the thickness of SOI film can be precisely controlled in the production of SOI wafer through SIMOX method.

That is, the summary and construction of the invention are as follows.
(1) A method of producing a SIMOX wafer by implanting oxygen ions into a surface of a Si substrate and then conducting a high-temperature annealing, in which a SOI film having a thickness thicker than a target SOI film thickness is previously formed and a final adjustment of the SOI film thickness is carried out at an etching step arranged separately from a cleaning step.

(2) A method of producing a SIMOX wafer according to item (1), wherein the cleaning step serves concurrently as the etching step.

(3) A method of producing a SIMOX wafer according to item (1) or (2), wherein the cleaning step is a batch cleaning, and a SOI film thickness just after the annealing is measured and an optimum etching time or a cleaning time including an etching is set every annealing batch to adjust the SOI film thickness.

(4) A method of producing a SIMOX wafer according to item (1) or (2), wherein the cleaning step is a sheet-feed cleaning, and a SOI film thickness just after the annealing is measured every the wafer and an optimum etching time or a cleaning time including an etching is set every the wafer to adjust the SOI film thickness.

(5) A method of producing a SIMOX wafer according to any one of items (1)-(4), wherein a treating solution used in the etching step or the cleaning step inclusive of etching is a SC-1 based solution or a HF+O₃ based solution.

According to the invention, there can be obtained SIMOX wafers being excellent in various qualities and very high in the thickness precision of SOI film.

### BRIEF DESCRIPTION OF THE DRAWING

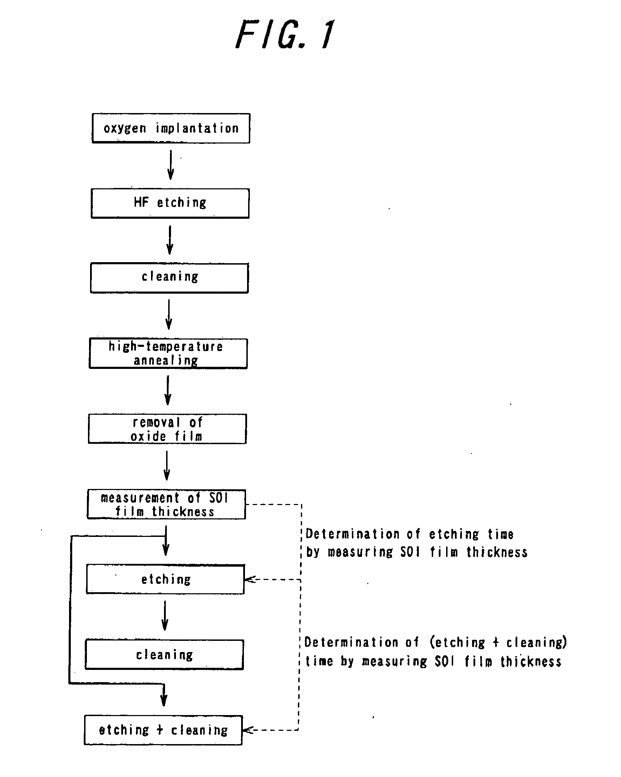

FIG. 1 is a flow chart showing a SIMOX process.

### DESCRIPTION OF PREFERRED EMBODIMENTS

The details of the invention will be explained below.

In the SIMOX process, an implantation energy is determined so as to ensure an adequate SOI film thickness in accordance with specifications of SOI film thickness and BOX film thickness. In this way, a depth of implanting oxygen is decided to roughly determine the SOI film thickness.

On the other hand, the buried oxide film (BOX) is formed based on oxygen implanted at this time, but the amount of oxygen implanted is not more than a half of an amount required for the BOX formation, so that a deficient oxygen is fed from exterior at an internal thermal oxidation (ITOX) step in the subsequent high-temperature annealing step. In this case, silicon on the surface is oxidized by several 100 nm, so that the SOI film thickness largely changes at this step.

In the SOI film thickness obtained by these processes, a good reliability is obtained to a certain level by controlling an implantation energy, an implantation dose, an implantation temperature, an annealing temperature, an annealing time, an oxygen partial pressure in annealing and the like, but the difference of the film thickness is caused in no small way in accordance with the difference of implantation conditions, difference of annealing batches and difference between wafers in the batch. Therefore, it can not be said that all wafers are set to a target film thickness. That is, the film thickness may be lower or higher than the target film thickness.

Now, if the thickness of the SOI film is somewhat higher than the target value, it can be precisely controlled by subjecting to a subsequent etching.

In the invention, therefore, the SOI film thickness is previously made somewhat higher than the target film thickness and thereafter the etching is conducted to control the film thickness to a desired thickness. That is, the thickness of SOI film to be formed is previously set to be higher by about 5-20 nm than the target film thickness, and after the high-temperature annealing, the oxide film is separated off to measure the thickness of SOI film, and an increment of the SOI film thickness measured exceeding the target film thickness is removed by etching, and thereafter the SOI film is subjected to a cleaning treatment.

In the invention, the cleaning step can serve concurrently as the etching step because the etching step is not necessarily arranged separately from the cleaning step. In this connection, FIG. 1 shows a flow chart of SIMOX process according to the invention.

According to the invention, a treating solution used in the etching treatment is not particularly limited as far as silicon can be etched, but a SC-1 based solution and HF+O₃ based solution are particularly preferable in view of a surface cleanness, surface roughness, surface uniformity of film thickness and control easiness of etching time.

The SC-1 based solution is a mixed solution of aqueous ammonia (NH₄OH) and aqueous hydrogen peroxide (H₂O₂) and has a typical composition of NH₄OH:H₂O₂:H₂O = 1:1:5. Also, the HF+O₃ based solution is obtained by adding ozone (O₃) to a diluted HF aqueous solution, in which it is preferable to have a HF concentration of 0.3-0.7 mass% and a O₃ concentration of 5-20 ppm.

Also, the treating solution used in the etching step and the treating solution used in the cleaning step may be same or different. However, when the cleaning step serves concurrently as the etching step, it is preferable to use the same kind of the treating solution.

Since the scattering of the film thickness between batches is commonly large, the value of the SOI film thickness is measured every the implantation batch or the annealing batch and the etching time or the (etching + cleaning) time is set every the batch, whereby the SOI film thickness every the batch can be adjusted to a value near to the target film thickness. In this case, a batch cleaning machine can be used.

Further, if the scattering in the batch comes into problem, the SOI film thickness is measured every the wafer and the etching time or (etching + cleaning) time can be optimized every the wafer. In this case, a sheet-feed cleaning machine can be used instead of the batch cleaning machine.

Moreover, the SIMOX process according to the invention can be applied to any of the high-dose method, low-dose method and MLD method, but is preferably applied to the MLD method.

The invention is described with respect to the case of applying to SIMOX process through the MLD method below.

### (Examples)

At first, oxygen ions are implanted into a Si substrate under conditions of an acceleration energy: 170 keV, a dose: 2.5x10¹⁷ cm⁻² and a substrate temperature: 400°C, and further an ion implantation is carried out at room temperature and a dose of 2x10¹⁵ cm⁻². Then, ITOX process is conducted at 1320°C for 10 hours and thereafter an annealing process of 1350°C and 10-20 hours is carried out in an Ar atmosphere (oxygen concentration: 4 volume%). In this SIMOX process, the thickness of SOI film to be formed is set to a value higher by about 10 nm than a target film thickness: 70 nm.

After the high-temperature annealing, the oxide film is removed off to measure the thickness of SOI film, and as a result, it has been confirmed that all of SOI films have a thickness higher by about 7-12 nm than the target film thickness.

Now, an increment of the film thickness exceeding the target value is removed by subjecting to an etching treatment using a SC-1 solution (NH₄OH:H₂O₂:H₂O = 1:1:5) as a treating solution and thereafter the cleaning treatment is conducted. Moreover, a part of the SOI films is simultaneously subjected to the etching treatment and the cleaning treatment.

The average film thickness (n = 25) and dispersion of the thus obtained SOI films are examined to obtain results as shown in Table 1. Moreover, the SOI film thickness is measured by using a spectroscopic ellipsometer of KLA.

For the reference, the thickness of SOI film produced by the conventional method instead of the process according to the invention is examined to obtain a result shown in Table 1.

In Table 1, Nos. 1-5 are comparative examples, and Nos. 6-10 are a case that the process according to the invention is applied to a batch treatment, and Nos. 11-15 are a case that the process according to the invention is applied to a sheet-feed treatment.

**Table 1**

| Batch No. | Average value (nm) | Dispersion (nm) | Remarks |
|---|---|---|---|
| 1 | 73 | 2.4 | Comparative Example |
| 2 | 74 | 3.0 | Comparative Example |
| 3 | 69 | 3.4 | Comparative Example |
| 4 | 72 | 2.0 | Comparative Example |
| 5 | 67 | 2.1 | Comparative Example |
| 6 | 71 | 0.7 | Invention Example |
| 7 | 69.2 | 0.8 | Invention Example |
| 8 | 70.9 | 0.9 | Invention Example |
| 9 | 69.7 | 0.8 | Invention Example |
| 10 | 70.4 | 0.9 | Invention Example |
| 11 | 70.3 | 0.3 | Invention Example |
| 12 | 69.8 | 0.4 | Invention Example |
| 13* | 70.2 | 0.3 | Invention Example |
| 14* | 69.9 | 0.4 | Invention Example |
| 15* | 70.2 | 0.2 | Invention Example |

| | | | |
|---|---|---|---|
| *: a case of simultaneously conducting the etching treatment and the cleaning treatment | | | |

As seen from Table 1, the thickness of SOI film can be controlled to a target value of 70 nm in a high precision and the scattering thereof is less.

## Claims

1. A method of producing a SIMOX wafer by implanting oxygen ions into a surface of a Si substrate and then conducting a high-temperature annealing, in which a SOI film having a thickness thicker than a target SOI film thickness is previously formed and a final adjustment of the SOI film thickness is carried out at an etching step arranged separately from a cleaning step.

2. A method of producing a SIMOX wafer according to claim 1, wherein the cleaning step serves concurrently as the etching step.

3. A method of producing a SIMOX wafer according to claim 1 or 2, wherein the cleaning step is a batch cleaning, and a SOI film thickness just after the annealing is measured and an optimum etching time or a cleaning time including an etching is set every annealing batch to adjust the SOI film thickness.

4. A method of producing a SIMOX wafer according to claim 1 or 2, wherein the cleaning step is a sheet-feed cleaning, and a SOI film thickness just after the annealing is measured every the wafer and an optimum etching time or a cleaning time including an etching is set every the wafer to adjust the SOI film thickness.

5. A method of producing a SIMOX wafer according to any one of claims 1-4, wherein a treating solution used in the etching step or the cleaning step inclusive of etching is a SC-1 based solution or a HF+O₃ based solution.
